# DEMANDE DE BREVET EUROPEEN

(11) **EP 0 807 855 A1**
(43) Date de publication de la demande: **19.11.1997**
(21) Numéro de dépôt: 97401067.0
(22) Date de dépôt: 14.05.1997
(51) Int. Cl.: G03F 9/00

(54) **Dispositif de support de cliché pour installation d'exposition à la lumière d'une pièce plane**

(30) Priorité: 15.05.1996 FR 9606061
(71) Demandeur: Automa-Tech, 27100 Val de Reuil (FR)
(72) Inventeur: Sorel, Alain, 27180 Les Baux St Croix (FR); Charbonnier, Serge, 27120 Chambray (FR)
(74) Mandataire: Dronne, Guy

(57) **Abrégé**

L'invention concerne un dispositif de support de cliché pour installation d'exposition à la lumière d'une pièce plane, ladite installation comprenant un bâti fixe (10) horizontal. Le dispositif comprend un support de cliché constitué par un cadre rectangulaire (14) et une glace (16) solidaire dudit cadre et apte à recevoir un cliché, des moyens de supportage ou de sustentation (18) dudit support apte à maintenir ledit support horizontal dans un plan donné et à produire une coopération sensiblement sans frottement entre ledit support et ledit bâti, des moyens (24) commandables pour réaliser une solidarisation temporaire entre ledit bâti et le cadre dudit support, et des moyens (20, 22) de déplacement solidaires dudit bâti pour déplacer ledit support par rapport audit bâti dans un plan horizontal selon deux directions orthogonales.

## Description

La présente invention a pour objet un dispositif de support de cliché pour installation d'exposition à la lumière d'une pièce plane et notamment d'une plaque de circuit imprimé.

Il existe notamment dans le domaine des techniques de fabrication de circuit imprimé de nombreux cas où il est nécessaire de positionner un cliché par rapport à la plaque de circuit imprimé pour réaliser une opération d'insolation.

C'est notamment le cas pour l'étape d'insolation en vue de la définition par photogravure des pistes conductrices du circuit imprimé. L'installation correspondante a pour fonction d'exposer aux ultraviolets pendant un temps donné les circuits imprimés recouverts d'un film ou d'une laque photosensible à travers un cliché monté sur un support mobile pour insoler la partie correspondante de la laque ou du film photosensible définie par le cliché.

On comprend bien sûr que, dans cette opération, un point fondamental consiste dans la précision du positionnement du cliché par rapport au circuit imprimé sur lequel on veut réaliser l'insolation. Le cliché est disposé sur un support horizontal constitué le plus souvent par un cadre rectangulaire métallique sur lequel est fixée une glace, le cliché étant disposé sur la glace afin de permettre l'insolation. Dans le cas particulier de l'invention, le dispositif de support concerne le cas où c'est le cliché qui doit être déplacé pour être positionné de façon précise par rapport à la pièce plane et, notamment, par rapport à la plaque de circuit imprimé.

Dans l'énorme majorité des machines de ce type, l'exposition aux ultraviolets concerne une seule face de la plaque de circuit imprimé. Dans ce cas, la machine comporte un seul support de cliché qui est un support inférieur. Cependant, lorsque la plaque de circuit imprimé est du type double face, ce qui est de plus en plus fréquent, l'utilisation de machines permettant l'insolation simultanée à travers deux clichés du circuit imprimé est d'un intérêt particulier. On a proposé de telles machines notamment dans le brevet américain 5,337,151 et dans la demande de brevet européen EP 618 505. Dans de telles machines, du fait de la présence des deux clichés, il est donc nécessaire de prévoir deux supports de clichés disposés de part et d'autre de la plaque du circuit imprimé.

Quel que soit le nombre de supports de clichés, dans les solutions proposés jusqu'ici, le support de cliché qui présente un certain poids, notamment du fait de la présence de la glace supportant le cliché et du poids du cadre qui doit présenter une grande rigidité, les déplacements sont obtenus à l'aide de deux dispositifs habituellement appelés tables, chaque dispositif permettant le déplacement du support selon une direction X ou selon les directions X et Y orthogonales entre elles. Ces tables supportent mécaniquement l'ensemble du support et doivent donc remplir la double fonction de moyen de déplacement dans un plan horizontal et de support mécanique dans la direction verticale. Cette double fonction fait que le moteur ou les moteurs, dans le cas d'un déplacement selon deux axes, doivent présenter une puissance non négligeable. En outre, compte tenu de la précision de positionnement que l'on veut obtenir, la masse et donc l'inertie de l'ensemble du support à déplacer font que les déplacements, même s'ils sont d'une amplitude limitée, se font avec une vitesse très réduite, ce qui entraîne un temps de positionnement du support, et donc du cliché par rapport à la pièce de référence, important, c'est-à-dire de l'ordre de plusieurs dizaines de secondes.

Dans le cas d'installation, par exemple d'insolation de circuit imprimé à partir de clichés disposés sur le support qui fonctionnent avec une alimentation automatique en circuits imprimés, ce temps nécessaire au positionnement du support réduit très sensiblement la cadence de fonctionnement de l'ensemble de l'installation.

Il existe donc un réel besoin de dispositifs de support de cliché qui puissent être déplacés avec une très grande précision, mais dans un laps de temps réduit par rapport aux solutions actuellement connues.

Un objet de la présente invention est de fournir un dispositif de support de cliché et, plus particulièrement, des moyens de déplacement de ce support qui permettent de réduire le temps nécessaire à la phase de positionnement final tout en conservant la même précision de positionnement.

Pour atteindre ce but, selon l'invention, le dispositif de support de cliché pour installation d'exposition à la lumière d'une pièce plane comprenant un bâti fixe horizontal, se caractérise en ce qu'il comprend :
un support de cliché constitué par un cadre rectangulaire et une glace solidaire dudit cadre et apte à recevoir un cliché,
- des moyens de supportage ou de sustentation dudit support apte à maintenir ledit support horizontal dans un plan donné et à produire une coopération sensiblement sans frottement entre ledit support et ledit bâti,
- des moyens commandables pour réaliser une solidarisation temporaire entre ledit bâti et le cadre dudit support, et
- des moyens de déplacement solidaires dudit bâti pour déplacer ledit support par rapport audit bâti dans un plan horizontal selon deux directions orthogonales.

On comprend qu'ainsi, les moyens de déplacement ou tables servent uniquement au déplacement du support de cliché et nullement à son supportage ou à sa sustentation dans le cas d'un support supérieur. De plus, le supportage sur support par rapport au bâti fixe est obtenu par des moyens qui n'induisent qu'un très faible frottement. On voit qu'ainsi, il est possible d'obtenir un positionnement très précis et très rapide du fait de la faible inertie mise en jeu. Cependant, grâce aux moyens de solidarisation temporaire du support sur le bâti, la position finale du support de cliché par rapport au bâti peut être maintenue constante durant l'opération d'exposition à la lumière.

D'autres caractéristiques et avantages de l'invention apparaîtront mieux à la lecture de la description qui suit d'un mode préféré de réalisation de l'invention donné à titre d'exemple non limitatif.

La description se réfère aux figures annexées sur lesquelles :
- la figure 1a est une vue schématique de dessus de la partie inférieure de l'installation d'exposition montrant le support inférieur de cliché;
- la figure 1b est une vue simplifiée en coupe verticale de l'installation montrant schématiquement les supports inférieur et supérieur;
- la figure 2 est une vue en élévation de moyens de solidarisation des supports de cliché par rapport au bâti;
- la figure 3 est une vue de détail montrant des moyens de supportage du support de cliché par le bâti; et
- la figure 4 est une vue de détail montrant un mode de réalisation des moteurs de déplacement du support inférieur ou du support supérieur de cliché par rapport aux bâtis fixes.

Dans ce type d'installation, il est bien connu que, dans un premier temps, on réalise un pré-positionnement du circuit imprimé par rapport au support de cliché à l'aide de doigts escamotables de positionnement. A partie de ce pré-positionnement du circuit imprimé par rapport au support de cliché supérieur et inférieur, on effectue par des moyens optiques une mesure de l'erreur de positionnement de ces trois parties. A partir de ces mesures d'erreur de positionnement, on commande des moteurs de déplacement pour réaliser le positionnement final qui doit correspondre à une erreur de positionnement inférieure à 10 microns. La présente invention concerne la partie de l'installation permettant d'obtenir le positionnement final à partir de la mesure de l'erreur correspondant au pré-positionnement.

La détection optique de l'erreur de positionnement a été décrite en détail dans la demande de brevet européen 618 505. Pour cette partie de l'installation, il est donc fait référence à la description de cette demande de brevet qui doit être considérée comme faisant partie intégrante de la présente demande.

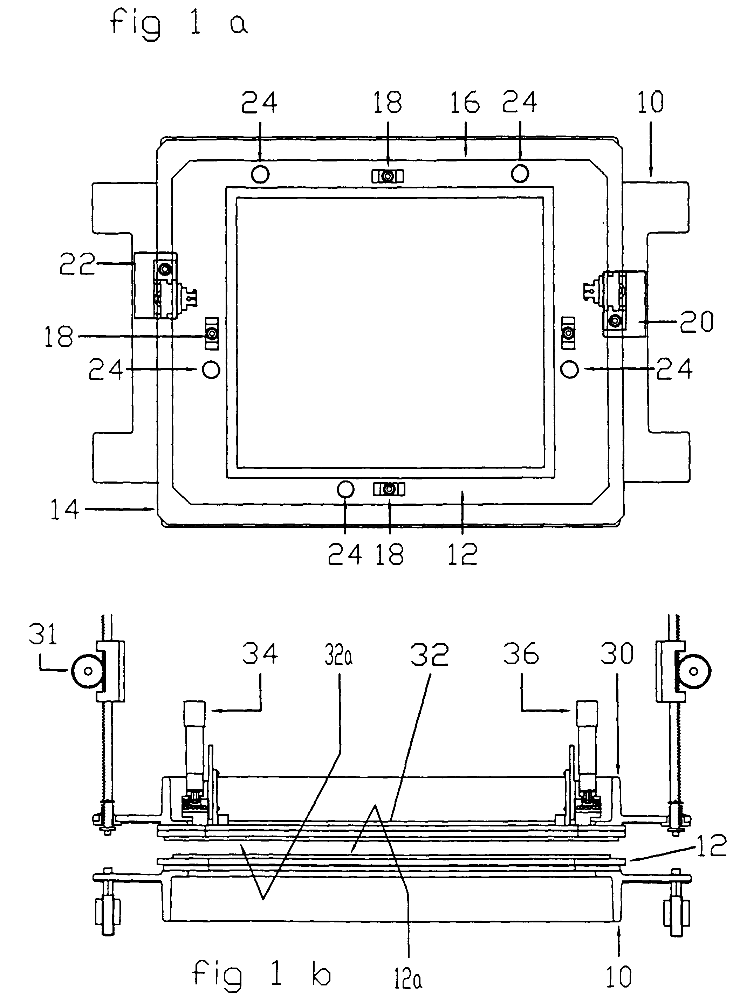

En se référant tout d'abord aux figures 1a et 1b, on va décrire les différentes parties de l'installation et, plus précisément, la partie inférieure de cette installation destinée à supporter le cliché inférieur et, d'une certaine manière, le circuit imprimé, et en particulier le support inférieur de cliché.

Sur la figure 1a, on a fait apparaître le bâti inférieur fixe de la machine référencé 10, ainsi que le support inférieur de cliché 12. Ce support inférieur 12 est constitué par un cadre métallique rectangulaire 14 sur lequel est fixée une glace 16, glace sur laquelle repose effectivement le cliché inférieur.

Dans l'installation d'exposition, le support inférieur de cliché 12 repose directement sur la face supérieure horizontale du bâti 10. Pour permettre les déplacements du support 12, celui-ci repose sur le bâti 10 par l'intermédiaire de systèmes de supportage à billes sans frottement, par exemple schématisés en 18. Dans l'exemple particulier, le supportage se fait par l'intermédiaire de quatre billes disposées sur les quatre côtés du cadre 14. Ce système, par exemple à billes qui sera décrit ultérieurement plus en détail permet de faire supporter mécaniquement l'ensemble du support inférieur par le bâti tout en assurant un supportage avec un frottement extrêmement réduit. On comprend que, grâce à cette disposition, l'effort qu'il faudra appliquer pour déplacer le support inférieur 12 sera donc très réduit, ce qui permettra de réduire en conséquence la puissance et donc la taille des moteurs servant à réaliser ce déplacement. On pourrait cependant utiliser d'autres moyens de supportage tel qu'un coussin d'air à condition qu'il ne produise qu'un frottement extrêmement réduit entre le cadre et le bâti.

Sur cette figure, on a également représenté schématiquement les dispositifs 20 et 22 de déplacement respectivement en X et en XY du support inférieur 12. Comme on l'a déjà expliqué, les tables de déplacement qui sont solidaires du bâti 10 ne réalisent aucune fonction de supportage et servent simplement à déplacer le support par rapport au bâti, étant ajouté que les frottements entre ces deux pièces étant très réduits et grâce à la présence des billes, l'énergie nécessaire est réduite. Sur la figure la, on a également représenté de façon schématique des freins électromagnétiques ou autre système de freinage similaire en 24. Ces systèmes de freinage 24 régulièrement répartis sur le cadre 14 permettent d'assurer l'immobilisation du cadre 14 et donc de l'ensemble du support inférieur de cliché 12 par rapport au bâti 10 lorsqu'un positionnement correct a été obtenu. Ces dispositifs de freinage 24 sont rendus nécessaires du fait de la liaison sans frottement entre le bâti et le support inférieur et du fait de la très faible puissance des moteurs utilisés pour réaliser les tables de déplacement 20 et 22.

La partie supérieure de la machine est constituée exactement de la même manière à l'exception du fait que le bâti inférieur 10 est immobile, aussi bien dans un plan horizontal que dans un plan vertical, alors que, bien entendu, le bâti supérieur est immobile dans un plan horizontal mais mobile dans un plan vertical pour permettre l'application du cliché supérieur sur le circuit imprimé et sur le cliché inférieur. On ne décrira donc pas en détail la partie supérieure de la machine.

La figure 1b montre en coupe verticale et de façon schématique l'ensemble de l'installation d'exposition. On retrouve le bâti inférieur fixe 10 sur lequel repose le support inférieur 12 destiné à recevoir le cliché inférieur 12a. Sur cette figure, on a également représenté le bâti supérieur 30 qui est supporté par l'intermédiaire de mécanismes 31 tels que des systèmes pignon crémaillère permettant de faire monter et descendre l'ensemble du bâti supérieur 30. Par ailleurs, ce bâti 30 est bien sûr fixe dans un plan horizontal. Sur le bâti supérieur 30, est monté le support supérieur 32 identique au support inférieur 12, destiné à recevoir le cliché supérieur 32a. Sur la figure 1b, on a représenté schématiquement les moteurs de déplacement en X et XY référencés 34 et 36 qui permettent de commander le déplacement du support 32 par rapport au bâti supérieur 30.

On comprend dès à présent le fonctionnement général de l'installation d'exposition selon l'invention:

Dans un premier temps, le bâti supérieur 30 étant écarté et les clichés 12a et 32a étant mis en place, on vient disposer entre les supports 12 et 32 le circuit imprimé à exposer. Le circuit imprimé à exposer est saisi à l'aide de dispositifs d'immobilisation non représentés qui permettent d'immobiliser dans un plan horizontal le circuit imprimé par rapport aux bâtis supérieur et inférieur. A l'aide des systèmes optiques non représentés, on mesure les erreurs de pré-positionnement du support inférieur 12 et du support supérieur 32 par rapport au circuit imprimé. Le circuit imprimé restant immobile, on commande à l'aide des moteurs 20, 22 et 34, 36 les déplacements convenables du support supérieur 32 et du support inférieur 12 afin d'obtenir un alignement des trois éléments ou, selon les cas, un alignement du support supérieur 32 avec la face supérieure du circuit imprimé et du support inférieur 12 avec la face inférieure du circuit imprimé. Lors que le positionnement correct est atteint ou commande les dispositifs de solidarisation 24, il va de soi que l'invention s'applique également à la réalisation de supports de cliché inférieur ou supérieur pour des installations d'exposition à un seul cliché. Dans ce cas, on a un seul support qui est en général le support inférieur.

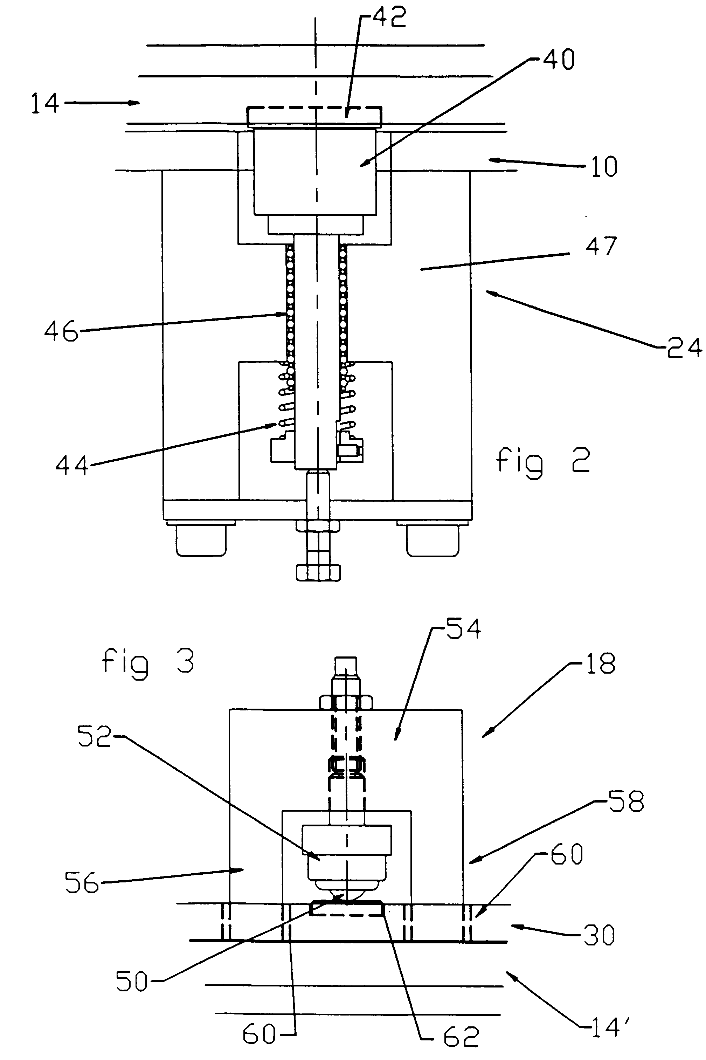

En se référant maintenant à la figure 2, on va décrire un exemple de réalisation du dispositif 24 de solidarisation du bâti inférieur 10 avec le cadre 14 du support inférieur 12. Des dispositifs identiques seraient utilisables pour réaliser la solidarisation du support supérieur 32 avec le bâti supérieur 30. Le système d'immobilisation est essentiellement constitué par une tête électromagnétique 40 qui, lorsqu'elle est activée, coopère avec une plaquette ferromagnétique 42 solidaire de la face inférieure du cadre 14 du support inférieur 12. En activant la tête magnétique 70, on obtient une solidarisation entre le bâti inférieur 10 et le support inférieur 12. La tête électromagnétique 40 est montée par l'intermédiaire d'un système élastique 44 et d'un système à billes 46. Ces dispositifs de solidarisation permettent de maintenir le positionnement rigoureux des supports supérieur et inférieur lors de l'abaissement du support supérieur pour réaliser un contact entre les deux clichés et les faces du circuit imprimé 40. Il va de soi que l'on pourrait utiliser d'autres systèmes de solidarisation du cadre du support de cliché sur le bâti, par exemple des systèmes à dépression ou, au contraire, des systèmes à jet d'air sous pression. Il faut nécessairement qu'ils soient commandables pour permettre un libre déplacement du support par rapport au bâti en dehors des phases d'activation.

En se référant maintenant à la figure 3, on va décrire un mode de réalisation des billes de supportage 18 permettant le supportage ou la sustentation du support par rapport aux bâtis respectivement inférieur et supérieur. La figure 3 illustre un dispositif de sustentation 18 reliant le cadre 14' du support supérieur 12' au bâti supérieur 30. Le dispositif à billes est essentiellement constitué par une bille métallique 50 montée rotulante dans une cage 52. La cage 52 est reliée par un système d'étrier 54 au cadre 14' du support supérieur. Pour cela, les bras 56 et 58 de l'étrier traversent le bâti 30 par des trous tels que 60. Pour assurer un meilleur roulement et donc diminuer encore le frottement, la bille 50 coopère avec une surface de roulement 62 solidaire de la face supérieure du bâti 30.

Dans le cas du supportage du cadre du support inférieur par le bâti, on a le même système à billes mais dont l'axe est inversé de telle manière que la cage 52 de la bille 50 soit solidaire du bâti inférieur 10 et que la bille coopère avec la face inférieure du cadre 14 du support inférieur 12.

Le système de supportage ou de sustentation pourrait également être constitué par des systèmes à coussin d'air interposés entre le cadre du support et le bâti.

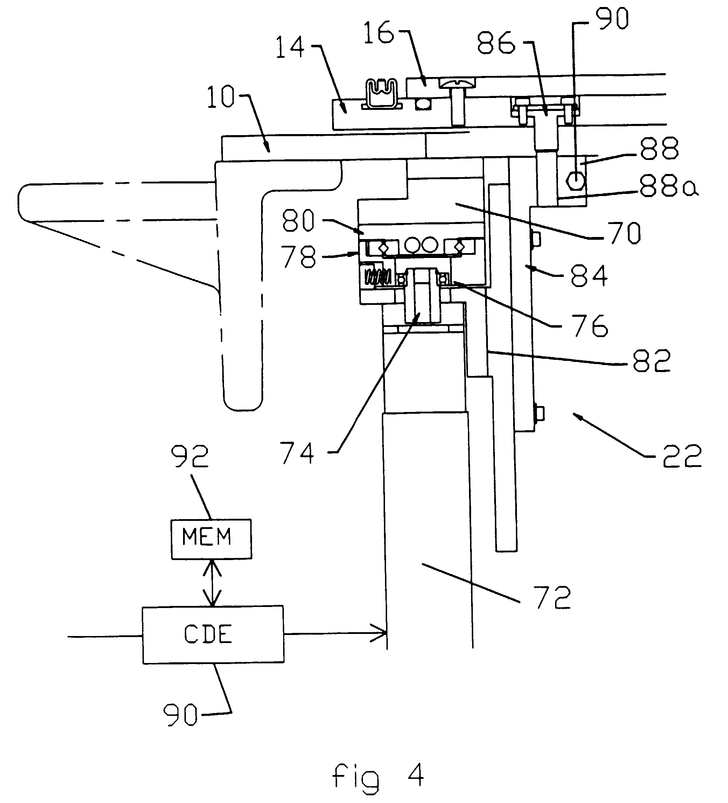

En se référant maintenant à la figure 4, on va décrire un mode préféré de réalisation des dispositifs de déplacement 20 et 22 ou 34 et 36 permettant le positionnement final de chaque support par rapport au bâti correspondant. Sur la figure 4, on a par exemple représenté le dispositif de déplacement 22 permettant un déplacement en X et en Y du support inférieur 12. Des systèmes de déplacement similaires sont utilisés en liaison avec le bâti supérieur 30. Le système de déplacement 22 présente un carter 70 qui est solidaire du bâti 10. Pour chaque déplacement en X ou en Y, on trouve un moteur, par exemple 72 solidaire du bâti 70. Ce moteur a son arbre 74 qui se termine par une came 76 permettant de déplacer une première table 78 de déplacement selon la direction X. Une deuxième table 80 coopérant avec la première et associée à un deuxième moteur qui contrôle le déplacement selon la direction Y et non représenté sur la figure. Par un renvoi mécanique 82, 84 solidaire de la deuxième table, le déplacement combiné en X et Y est appliqué à une pièce 88 qui définit un alésage vertical 88a. Un ergot vertical 86 solidaire de la face inférieure du cadre 14 du support peut pénétrer librement dans l'alésage 88a. Le jeu, dans le plan horizontal entre la pièce 88 et l'ergot 86 est très réduit mais il n'y a pas de serrage. Pour adapter ce jeu, de préférence la pièce 88 est une bague fendue munie de l'écrou 90 qui permet d'adapter avec précision le diamètre de l'alésage 88a au diamètre de l'ergot 86. Ce mode de liaison entre les moyens de déplacement 22 et le support 12 permet d'éviter l'introduction d'un couple de torsion. On pourrait prévoir le montage inverse dans lequel l'ergot serait solidaire de la table et l'alésage axial serait réalisé dans le cadre du support.

Afin d'améliorer encore la précision des déplacements du support malgré d'éventuels imprécisions dans le profilé des cames, on peut adopter une commande électronique de la rotation de chaque moteur. Cette commande est réalisée par l'intermédiaire d'une table de correspondance entre l'angle de rotation de la came particulière utilisée et le déplacement effectif de la table en X ou en Y. Cette table est mémorisée dans les circuits de commande. A partir de l'information de déplacement en X ou en Y à effectuer, le circuit détermine l'angle de la rotation à effectuer et la commande correspondante est appliquée au moteur.

## Revendications

1. Dispositif de support de cliché pour installation d'exposition à la lumière d'une pièce plane, ladite installation comprenant un bâti fixe horizontal, caractérisé en ce qu'il comprend :
un support de cliché constitué par un cadre rectangulaire et une glace solidaire dudit cadre et apte à recevoir un cliché,
- des moyens de supportage ou de sustentation dudit support apte à maintenir ledit support horizontal dans un plan donné et à produire une coopération sensiblement sans frottement entre ledit support et ledit bâti,
- des moyens commandables pour réaliser une solidarisation temporaire entre ledit bâti et le cadre dudit support, et
- des moyens de déplacement solidaires dudit bâti pour déplacer ledit support par rapport audit bâti dans un plan horizontal selon deux directions orthogonales.

2. Dispositif selon la revendication 1, caractérisé en ce que les moyens de supportage ou de sustentation comprennent des moyens par bille interposés entre le cadre du support et le bâti.

3. Dispositif selon l'une quelconque des revendications 1 et 2, caractérisé en ce que les moyens commandables de solidarisation temporaire comprennent des moyens par électroaimant solidaires dudit bâti.

4. Dispositif selon l'une quelconque des revendications 1 à 3, caractérisé en ce que lesdits moyens de déplacement comprennent deux ensembles de déplacement au moins, un desdits ensembles comprenant un premier moteur solidaire dudit bâti, des moyens pour came solidaires de l'arbre de sortie dudit premier moteur pour déplacer une première table selon la direction X, une deuxième table coopérant avec ladite première table pour être déplacée selon la direction X en synchronisme avec la première table, des deuxièmes moyens moteurs solidaires de ladite première table, des moyens par came solidaires de l'arbre de sortie dudit deuxième moteur pour déplacer ladite deuxième table selon la direction Y orthogonale à la direction X, la liaison entre la deuxième table et le cadre du support étant réalisée par un doigt vertical de déplacement pénétrant librement dans un alésage axial vertical, le doigt étant solidaire du support ou de la deuxième table, l'alésage étant solidaire de l'autre pièce.

5. Dispositif selon la revendication 4, caractérisé en ce que chaque moteur (72) comprend un circuit de commande (94) associé à une mémoire (92) dans laquelle est stockée une table de correspondance entre les angles de rotation de la came (76) montée sur le moteur et le déplacement linéaire de la table (78, 80) associée.
